# EUROPÄISCHE PATENTANMELDUNG

(11) **EP 2 437 581 A1**
(43) Veröffentlichungstag der Anmeldung: **04.04.2012**
(21) Anmeldenummer: 10183306.9
(22) Anmeldetag: 30.09.2010
(51) Int. Cl.: H05K 1/03, H01L 25/075, H01L 33/62, F21K 99/00, H05K 1/18

(54) **Leuchtdiode auf Keramiksubstratbasis**

(71) Anmelder: Odelo GmbH, 71409 Schwaikheim (DE)
(72) Erfinder: Kolbe, Leonore, 47495, Rheinberg (DE); Kunze, Jochen, 47441, Moers (DE)
(74) Vertreter: Benninger, Johannes

(57) **Zusammenfassung**

Es wird eine Leuchtdiode (01) auf Keramiksubstratbasis beschrieben. Die Leuchtdiode (01) auf Keramiksubstratbasis umfasst ein Keramiksubstrat (02) und mindestens einen auf dem Keramiksubstrat (02) angeordneten und elektrisch kontaktierten LED-Chip (03). Die Leuchtdiode (01) auf Keramiksubstratbasis zeichnet sich durch ein aus mehreren laminierten Grünlagen (04) hergestelltes Keramiksubstrat (02) aus.

## Beschreibung

Die Erfindung betrifft eine Leuchtdiode auf Keramiksubstratbasis gemäß dem Oberbegriff des Anspruchs 1.

Als Lichtquelle beispielsweise für Leuchten, wie etwa Kraftfahrzeugleuchten, kommen wegen ihres geringen Stromverbrauchs vermehrt Leuchtdioden zum Einsatz. Die Leuchtdioden sind hierbei einzeln oder gruppenweise auf einem mit Leiterbahnen zur elektrischen Kontaktierung versehenen Leuchtmittelträger angeordnet, welcher im Leuchteninnenraum so platziert werden kann, dass das von den Leuchtdioden ausgestrahlte Licht möglichst verlustarm durch wenigstens eine den Leuchteninnenraum abschließende Lichtscheibe hindurch aus der Leuchte austritt. Bei dem Leuchtmittelträger handelt es sich im einfachsten Fall um eine oder mehrere im Leuchteninnenraum angeordnete, ebene (2-D) Platinen, im aufwändigsten Fall um einen in Form eines oder mehrerer spritzgegossener Schaltungsträger (MID; Molded-Interconnect-Device) ausgeführten, komplex geformten (3-D) und mit integrierten Leiterbahnen ausgeführten Leuchtmittelträger mit integrierter mechanischer und elektronischer Funktion.

Eine als Lichtquelle vorgesehene Leuchtdiode besteht zumindest aus wenigstens einem LED-Chip (LED; Lichtemittierende Diode), sowie aus mindestens einem Kontaktmittel zur elektrischen Kontaktierung des LED-Chips. Üblicherweise verfügt jede Leuchtdiode über einen Bonddraht je LED-Chip, welcher je einen LED-Chip elektrisch kontaktiert. Dieser Bonddraht bildet wenigstens ein Kontaktmittel der Leuchtdiode. Der Bonddraht kann mit einem elektrischen Anschluss verbunden sein, welcher zur elektrischen Kontaktierung mit einer Leiterbahn des Leuchtmittelträgers vorgesehen ist. Der LED-Chip selbst ist darüber hinaus beispielsweise über einen zweiten elektrischen Anschluss mit einer zweiten Leiterbahn des Leuchtmittelträgers verbunden. Die Leuchtdiode kann einen den LED-Chip unmittelbar umgebenden Primärreflektor aufweisen. Dieser Primärreflektor kann beispielsweise durch Wandungen einer den LED-Chip umgebenden Ausnehmung und/oder durch einen Napf gebildet sein, in dem der LED-Chip angeordnet ist. Der Napf kann mit dem erwähnten zweiten Anschluss verbunden sein, diesen bilden oder umfassen oder von diesem umfasst werden. Der zweite Anschluss bildet ebenfalls ein Kontaktmittel der Leuchtdiode. Der zweite Anschluss kann jedoch auch entfallen, indem der LED-Chip selbst unmittelbar auf einer ersten Leiterbahn des Leuchtmittelträgers platziert wird. In diesem Fall bildet der mit einer zweiten Leiterbahn verbundene Bonddraht das einzige Kontaktmittel der Leuchtdiode.

Darüber hinaus ist bekannt, alternativ oder zusätzlich Linsen unmittelbar vor dem LED-Chip sowie einem gegebenenfalls diesen unmittelbar umgebenden Primärreflektor anzuordnen, beispielsweise um eine in Abhängigkeit von einem vorgegebenen Einsatzzweck erforderliche Lichtverteilung und/oder Lichtbündelung zu erhalten. Derartige in unmittelbarer Nähe zum LED-Chip angeordnete Linsen werden auch als Primäroptiken bezeichnet.

Eine Leuchtdiode, die mit einer Primäroptik versehen ist, wird im Nachfolgenden als belinste Leuchtdiode bezeichnet.

Die unterschiedlichen elektrischen Kontaktierungsmöglichkeiten des LED-Chips werden nachfolgend unter Bezugnahme auf die unterschiedlichen, bekannten Ausgestaltungen von Leuchtdioden verdeutlicht.

Bekannt sind Leuchtdioden zur Durchsteckmontage (THT; Through Hole Technology), oberflächenmontierbare (SMD; Surface Mounted Device) Leuchtdioden und Leuchtdioden, bei denen der LED-Chip in Nacktmontagetechnik (COB; Chip On Board) direkt auf den Leuchtmittelträger gebondet wird.

THT-Leuchtdioden sind der gängig bekannte Typ Leuchtdioden. Sie werden auch als bedrahtete Leuchtdioden bezeichnet, da sie aus einer zumindest in einer
gewünschten Abstrahlrichtung transparenten Kapselung, z.B. in Form einer Umspritzung oder eines Vergusses bestehen, welche den mit einem Kathodenanschluss verbundenen LED-Chip und einen den LED-Chip mit einem Anodenanschluss verbindenden Bonddraht einschließt. Aus der Kapselung ragen nur die Drähte des Anoden- und des Kathodenanschlusses als die elektrischen Anschlüsse. Der Kathodenanschluss kann hierbei mit einem oben erwähnten Napf versehen sein, in dem der LED-Chip angeordnet ist. Der Bonddraht führt vom Anodenanschluss von außerhalb des Napfs kommend zum LED-Chip.

Um eine belinste THT-Leuchtdiode herzustellen ist bekannt, die Kapselung direkt, beispielsweise während oder nach deren Herstellung im Spritzgießprozess mit einer Primäroptik zu versehen. Durch DE 101 63 117 C1 ist ein Verfahren bekannt, eine belinste THT-Leuchtdiode durch einen zweistufigen Spritzgießprozess herzustellen. Durch DE 10 2004 014 355 B4 ist bekannt, eine belinste THT-Leuchtdiode durch Ur- und Umformen herzustellen.

Belinste THT-Leuchtdioden sind robust beim Umgang während der Lagerung und Montage z.B. auf einem Leuchtmittelträger und weisen eine hohe optische Effizienz auf.

Nachteilig an THT-Leuchtdioden ist deren hoher Montageaufwand bei der Anordnung und elektrischen Kontaktierung auf einem Leuchtmittelträger. Der hohe Montageaufwand ist bedingt durch die Vielzahl gesondert erforderlicher Montageschritte. Zunächst muss das Einfädeln der Drähte des Anoden- und des Kathodenanschlusses in eigens hierfür vorgesehene Öffnungen am Leuchtmittelträger erfolgen. Dann müssen die Drähte des Anoden- und des Kathodenanschlusses durch die Öffnungen hindurch und anschließend auf der Rückseite des Leuchtmittelträgers umgebogen werden, so dass sie auf den entsprechenden Leiterbahnen zum liegen kommen. Anschließend muss die Herstellung der elektrischen Verbindung zwischen den Drähten des Anoden- und des Kathodenanschlusses und den entsprechenden Leiterbahnen auf dem Leuchtmittelträger von der den THT-Leuchtdioden abgewandten Rückseite des Leuchtmittelträgers her beispielsweise durch Verlöten oder Schweißen durchgeführt werden. Darüber hinaus weisen THT-Leuchtdioden einen schlechten Wärmehaushalt auf, bedingt durch deren vollständige und relativ dicke Kapselung. Hierdurch ist ein relativ hoher Wärmegradient vom LED-Chip zur Umgebung nötig, um durch die Kapselung hindurch einen bestimmten Verlustwärmestrom abzugeben.

SMD-Leuchtdioden bestehen aus einem Leadframe mit wenigstens einer Montagefläche für mindestens einen LED-Chip sowie elektrischen Anschlussflächen. Das Leadframe ist von einem Kunststoffkörper mit zumindest einer die wenigstens eine Montagefläche freihaltenden Ausnehmung teilweise umspritzt. Die elektrischen Anschlussflächen des Leadframes sind hierbei zur späteren Oberflächenmontage ebenfalls freigehalten. Der mindestens eine LED-Chip ist am Grund der zumindest einen zur wenigstens einen Montagefläche reichenden Ausnehmung angeordnet und elektrisch kontaktiert. Dabei ist der LED-Chip auf einem mit wenigstens einer ersten elektrischen Anschlussfläche verbundenen ersten elektrischen Anschluss angeordnet. Ein Bonddraht verbindet den LED-Chip mit einem zweiten elektrischen Anschluss, der wiederum mit wenigstens einer zweiten elektrischen Anschlussfläche verbunden ist. Die an ihrem Grund zur Montagefläche reichende Ausnehmung kann reflektorartig ausgestaltet sein. Dabei bilden die Wandungen der Ausnehmung den oben erwähnten Primärreflektor. Hierbei können die Wandungen reflektierend beschichtet sein.

Als Primäroptik belinster SMD-Leuchtdioden werden bisher üblicherweise Aufsteckoptiken oder aufgeklebte Optiken verwendet.

Durch EP 2 075 856 A2 ist eine belinste SMD-Leuchtdiode bekannt. Die SMD-Leuchtdiode besteht aus einem Leadframe mit einer Montagefläche für einen LED-Chip. Das Leadframe ist zum Teil von einem opaken, spritzgegossenen Kunststoffkörper umhüllt. Der Kunststoffkörper weist an der Oberseite des Leadframes eine Ausnehmung auf, an deren Grund sich die Montagefläche befindet. Die Ausnehmung mit schrägen Wandungen ist vom Leadframe aus gesehen divergent. Eine die Ausnehmung mit dem darin angeordneten LED-Chip abschließende Linse als Primäroptik ist beispielsweise an den schrägen Wandungen der Ausnehmung an dem Kunststoffkörper befestigt. Die Linse kann beispielsweise durch Kleben oder mechanisch am Kunststoffkörper befestigt sein. Die Linse schließt einen in der Ausnehmung verbleibenden, den LED-Chip beherbergenden Aufnahmeraum ab. Zwischen LED-Chip und Linse verbleibt ein einen den LED-Chip beherbergenden Aufnahmeraum bildender Zwischenraum, der zumindest zum Teil mit einer transparenten Masse verfüllt sein kann.

Belinste SMD-LEDs können im Reflow-Verfahren kostengünstig auf einem Leuchtmittelträger montiert werden.

Nachteilig an belinsten SMD-Leuchtdioden nach dem Stand der Technik ist, dass sie wegen der erforderlichen Vielzahl von Verfahrensschritten zur Herstellung der einzelnen Bauteile und dem sich daran anschließenden Zusammenbau der Bauteile zur fertigen belinsten SMD-Leuchtdiode nicht kostengünstige hergestellt werden können.

Darüber hinaus ist eine erwünschte hohe optische Effizienz von derart hergestellten SMD-Leuchtdioden aufgrund der Vielzahl optischer Grenzflächen im Strahlengang vom LED-Chip durch die einen Teil des Zwischenraums zwischen LED-Chip und Linse einnehmenden transparenten Masse hindurch in einen gegebenenfalls verbleibenden, gasbefüllten Teil des Zwischenraums und von diesem zur Linse bis zum Austritt aus derselben heraus nicht gegeben. Ein weiterer Nachteil ergibt sich durch eine ungenaue Positionierung der Primäroptik relativ zum LED-Chip. Die ungenaue Positionierung ergibt sich z.B. durch Toleranzen des Kunststoffkörpers und der Linse sowie durch Toleranzen bei der Positionierung der Linse während des Befestigens am Kunststoffkörper.

Nachteile eines Aufsteckens oder Aufklebens einer Primäroptik auf eine SMD-Leuchtdiode sind außerdem eine relativ große Bauhöhe der Leuchtdiode, was zu einem höheren Bauraumbedarf in der Leuchte führt, einem zusätzlichen und daher teuren Verfahrensschritt zu deren Herstellung, sowie der großen Toleranz bei der Positionierung der Primäroptik und damit geringen Genauigkeit der Abstrahlcharakteristik. Bei Kraftfahrzeugleuchten, bei denen die Leuchtdiode in einem externen Reflektor zur Strahlformung untergebracht ist, wie beispielsweise bei Heckleuchten-Anwendungen vorgesehen, ist aufgrund der geringen Genauigkeit der Abstrahlcharakteristik eine große Bautiefe des externen Reflektors notwendig, um möglichst viel Licht mit dem Reflektor aufzufangen.

COB-Leuchtdioden bestehen aus einem direkt auf einem Leuchtmittelträger anzuordnenden, ungehäusten LED-Chip und einem Bonddraht. Zur elektrischen Kontaktierung wird der LED-Chip direkt mit einer ersten Leiterbahn eines Leuchtmittelträgers z.B. durch Löten oder Schweißen elektrisch verbunden. Der den zweiten elektrischen Kontakt des LED-Chips bildende Bonddraht wird mit einer zweiten Leiterbahn des Leuchtmittelträgers ebenfalls z.B. durch Löten oder Schweißen elektrisch verbunden.

Zum Belinsen von COB-Leuchtdioden ist bekannt, den direkt auf den Leuchtmittelträger gebondeten LED-Chip anschließend mit einer transparenten Masse, z.B. einer Silikonmasse oder einem Kunststoff unter anderem zu dessen Schutz zu vergießen. Hierdurch lassen sich jedoch nur einfache Geometrien der Primäroptik herstellen. Durch DE 103 57 818 B4 ist ein Verfahren bekannt, COB-Leuchtdioden gegenüber einem biegesteifen oder biegeweichen Leuchtmittelträger auszurichten und daraufhin thermisch leitend, mechanisch und elektrisch mit dem Leuchtmittelträger und den entsprechend vorgesehenen Leiterbahnen zu verbinden. Im Anschluss hieran wird der Leuchtmittelträger mit der oder den darauf montierten COB-Leuchtdioden in eine Spritzgießform eingebracht. Die Spritzgießform wird dann mit einem nach dem Aushärten transparenten Thermoplast ausgespritzt, der den Leuchtmittelträger durch mindestens einen Durchbruch hindurch durchdringt oder umfließt. Hierdurch lassen sich Geometrien höherer optischer Effizienz verwirklichen, als beim freien Umgießen mit Harz oder Silikon.

Vorteile von COB-Leuchtdioden sind deren hervorragenden thermischen Eigenschaften durch deren im Vergleich mit belinsten THT-Leuchtdioden und belinsten SMD-Leuchtdioden beste Wärmeableitung durch direkten Kontakt des LED-Chips mit dem Leuchtmittelträger.

Nachteilig an COB-Leuchtdioden ist deren insbesondere bis zum Aufbringen einer gegebenenfalls vorgesehenen Vergussmasse hohe Empfindlichkeit bei Lagerung und Umgang, einhergehend mit einem hohen Aufwand zur Qualitätskontrolle nach Montage der COB-Leuchtdioden auf einem Leuchtmittelträger und vor Herstellung der Primäroptik mittels des Vergusses.

Zusammengefasst weisen COB-Leuchtdioden durch ihre gute wärmetechnische Anbindung sehr gute thermische Eigenschaften auf, wohingegen THT-Leuchtdioden wegen der Möglichkeit einer individuellen Ausgestaltung auch komplexer Primäroptiken durch Spritzgießen sehr gute optische Eigenschaften aufweisen.

Verwendet werden jedoch überwiegend SMD-Leuchtdioden wegen ihrer prozesstechnisch zuverlässigen, kostengünstigen und einfachen Montage z.B. im Reflow-Lötverfahren auf einen Leuchtmittelträger, obgleich SMD-Leuchtdioden jedoch weder thermisch noch optisch die Effizienz von nach einer der beiden anderen Technologien hergestellten Leuchtdioden erreichen können.

Um die thermische Effizienz von SMD-Leuchtdioden zu verbessern sind SMD-Leuchtdioden auf Basis von Keramiksubstraten bekannt. Die verwendeten Keramiksubstrate ersetzen dabei die vom Kunststoffkörper umspritzten metallischen Leadframes. Die Keramiksubstrate weisen hierbei einen gut auf den LED-Chip angepasstem Wärmeausdehnungskoeffizienten sowie eine ausreichend gute Wärmeleitfähigkeit auf. SMD-Leuchtdioden auf Keramiksubstratbasis werden in der Regel nur in Anwendungsfällen verwendet, in denen ein besonders guter thermischer Aufbau zwingend erforderlich ist, da das eingesetzte Keramiksubstrat sehr hohe Mehrkosten bedeutet.

Durch DE 203 12 246 U1 ist eine SMD-Leuchtdiode auf Keramiksubstratbasis mit einem Primärreflektor bekannt. Der Primärreflektor ist durch eine z.B. reflektierend beschichtete Ausnehmung im Keramiksubstrat gebildet. Am Grund der Ausnehmung ist ein LED-Chip angeordnet.

Sämtliche bekannten Leuchtdioden weisen außerdem den Nachteil auf, dass sie einer großen Lagerhaltung bedürfen, um z.B. Leuchtdioden mit abweichenden optischen und/oder elektrischen Eigenschaften voneinander getrennt sortiert aufzubewahren. Diese Lagerhaltung ist erforderlich, um abweichende elektrische und/oder optische Eigenschaften von zur gruppenweisen Verwendung innerhalb z.B. einer Lichtquelle oder eines Leuchtdiodenarrays vorgesehener Leuchtdioden durch Auswahl von Leuchtdioden gleicher oder ähnlicher elektrischer und/oder optischer Eigenschaften kompensieren zu können.

Alternativ oder zusätzlich zu einer großen Lagerhaltung kann zur Angleichung unterschiedlicher Helligkeiten mehrerer gruppenweise betriebener Leuchtdioden eines Leuchtdiodenarrays eine elektronische Steuerschaltung vorgesehen sein, die beispielsweise auf einem in einem Leuchteninnenraum untergebrachten Leuchtmittelträger angeordnet sein kann.

Insbesondere bei automobilen Anwendungen sind Vorwiderstände für die Anpassung der Vorwärtsspannung der Leuchtdioden an das Bordnetz notwendig. Üblicherweise werden die Leuchtdioden im so genannten Binning nach Vorwärtsspannung und Intensität sortiert. Um Unterschiede in einem Leuchtenmodul aus einem oder mehreren Leuchtdiodenarrays mit mehreren verschalteten Leuchtdioden auszugleichen und eine homogene Helligkeitsverteilung zu erhalten, wird zumindest jeder Leuchtdiodenstrang mit einem anderen Vorwiderstand versehen. Da die Leuchtdioden üblicherweise in verschiedene Spannungs- und Helligkeitsklassen unterteilt werden, potentiert sich die Anzahl der bereitzustellenden unterschiedlichen Widerstandswerte entsprechend.

Weitere Nachteile bekannter Leuchtdioden sind, dass sie z.B. beim Einsatz als Lichtquelle insbesondere in Kraftfahrzeugen einer separaten Ausfallerkennung bedürfen. Dies ist bedingt durch die geringe Leistungsaufnahme von Leuchtdioden im Allgemeinen. Beispielsweise ist ein in einem Kraftfahrzeug untergebrachtes Steuergerät nicht in der Lage, eine dem Ausfall einer oder weniger Leuchtdioden entsprechende Änderung der Leistungsentnahme aus dem Bordnetz zu erkennen, da eine hieraus resultierende Bordnetzspannungsänderung unterhalb der im normalen Betrieb eines Kraftfahrzeugs auftretenden Bordnetzspannungssschwankung liegt. Eine in der Kraftfahrzeugleuchte untergebrachte elektronische Schaltungsanordnung zur Ausfallerkennung erfasst den Ausfall einer oder mehrerer Leuchtdioden in der Kraftfahrzeugleuchte z.B. mittels eines oder mehrerer Komparatoren und teilt dies dem Steuergerät mit. Diese elektronische Schaltungsanordnung zur Ausfallerkennung kann durch eine beispielsweise auf dem Leuchtmittelträger aufgebrachte elektronische Steuerschaltung verwirklicht sein.

Darüber hinaus können die bekannten Leuchtdioden weiterer elektronischer Steuerschaltungen bedürfen. Beispiele hierfür sind elektronische Steuerschaltungen:
- zur Regelung und/oder Steuerung der Helligkeit bzw. Leuchtkraft von Leuchtdioden, beispielsweise durch eine pulsweitenmodulierte Taktung der Stromversorgung für einen außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der Leuchtdiode z.B. vor einer Überspannung des Bordnetzes oder vor fehlerhafter Polung, beispielsweise umfassen eine oder mehrere Zenerdioden,
- zur Anpassung und Homogenisierung der Leuchtkraft einzelner Leuchtdioden innerhalb eines gruppenweise betriebenen Leuchtdiodenarrays.

Zusammengefasst muss für fast alle Leuchtdioden-Anwendungen eine mehr oder minder umfangreiche, für die speziellen Leuchtdioden ausgelegte elektronische Steuerschaltung z.B. auf eine Platine aufgebracht werden. Die elektronische Steuerschaltung umfasst im einfachsten Fall einen Vor-Widerstand und eine Schutzdiode, kann aber je nach Anwendung auch wesentlich mehr Elektronikbauteile enthalten, wie z.B. Kondensatoren, Ferrite, etc. Derartige elektronische Steuerschaltungen auf einem Leuchtmittelträger oder einer separaten, im Leuchteninnenraum untergebrachten Platine auszuführen ist zeitaufwändig und kostspielig.

Elektronikbauteile, die zum Betreiben der Leuchtdiode notwendig sind, werden hierbei auf dem Leuchtmittelträger oder auf einer Platine aufgebracht. Die verschiedenen Widerstände, die für die Verschaltung notwendig sind müssen in entsprechender Stückzahl angeschafft und auf Lager gehalten werden. Jedes Helligkeits- und Vorwärtsspannungs-Bin jeder Leuchtdiode wird dabei einem bestimmten Vorwiderstandswert zugeordnet. Die Vorwiderstände werden beispielsweise als SMD-Bauelemente oder THT-Bauelemente separat auf den Leuchtmittelträger oder auf eine Platine bestückt. Des weiteren werden schaltungstechnisch notwendige diskrete SMD-Bauelemente, wie beispielsweise Kondensatoren, Ferrite, Spulen, Schutzdioden, separat auf den Leuchtmittelträger oder auf eine Platine bestückt.

Durch DE 10 2005 058 884 A1 ist ein Leuchtdiodenmodul mit mindestens zwei auf einem Keramikträger angeordneten LED-Chips bekannt. Das Leuchtdioden-Modul umfasst eine ebenfalls auf dem Keramikträger angeordnete Steuerschaltung. Die Steuerschaltung regelt die Lichtfarbe und/oder Leuchtstärke der auf dem Keramikträger angeordneten LED-Chips.

Durch DE 11 2008 000 704 T5 sind ein elektronisches Modul auf Keramiksubstratbasis aus mehreren laminierten Grünlagen sowie eine Konfiguration laminierter Grünlagen-Stapel bekannt.

Ein Ziel bei der Entwicklung und Herstellung von Kraftfahrzeugkomponenten und - teilen, wie etwa von Leuchtdioden als Lichtquellen für Kraftfahrzeugleuchten, ist eine einfache, zeitsparende und kostengünstige Herstellung, ein einfacher und kostengünstiger Umgang während Lagerung und Herstellung, sowie eine einfache und kostengünstige Montage auf dem Leuchtmittelträger.

Leuchtdioden mit einer aufwändige Lagerhaltung und/oder mit Herstellungsund/oder Montagekonzepten, welche eine Vielzahl von jeweils zeitaufwändigen Arbeitsschritten zur Herstellung einzelner Bauteile, von mechanischen und/oder elektrischen Verbindungen zwischen einzelnen Bauteilen und/oder Bauteilgruppen oder der Leuchtdioden auf einem Leuchtmittelträger vorsehen, stehen diesem Ziel entgegen.

Eine Leuchtdiode, welche ohne aufwändige Lagerhaltung und ohne gesonderte Bestückung der Bauteile auskommt, ist nicht bekannt. Ebenso ist keine Leuchtdiode bekannt, die sowohl optisch als auch thermisch effizient ist.

Eine Aufgabe der Erfindung ist es, eine Leuchtdiode zu entwickeln, welche eine hohe optische und thermische Effizienz aufweist und welche einfach und kostengünstig montiert werden kann und darüber hinaus einfach und unempfindlich in Umgang und Lagerung ist.

Die Aufgabe wird gelöst durch eine Leuchtdiode auf Keramiksubstratbasis mit den Merkmalen des unabhängigen Anspruchs 1.

Demnach ist zur Lösung der gestellten Aufgabe eine Leuchtdiode auf Keramiksubstratbasis vorgesehen. Die Leuchtdiode umfasst ein Keramiksubstrat und mindestens einen auf dem bzw. am oder im Keramiksubstrat angeordneten und elektrisch kontaktierten LED-Chip. Das Keramiksubstrat ist aus mehreren laminierten Grünlagen hergestellt. Die laminierten Grünlagen sind unter Druck und gleichzeitiger Wärmezufuhr zu Keramikträgern gesintert, so dass das Keramiksubstrat mehrlagig aus Keramikträgern besteht.

Auf oder in einen solchen durch eine oder mehrere Grünlagen gebildeten Keramikträger des Keramiksubstrats kann ein LED-Chip durch Die- und Wire-Bonden entsprechend einer COB-ähnlichen Technologie eingebracht und gebondet sein. Hierdurch wird eine besonders gute wärmetechnische Anbindung des LED-Chips erreicht. Die Leuchtdiode auf Keramiksubstratbasis weist dadurch eine sehr gute Wärmeableitung auf und erreicht dadurch thermische Eigenschaften wie COB-Leuchtdioden.

Alternativ kann der LED-Chip in eine Grünlage des Keramiksubstrats integriert sein. Hierdurch wird ebenfalls eine sehr gute Wärmeanbindung erreicht.

Wenigstens eine laminierte Grünlagen ist vorzugsweise mit zumindest einer Montagefläche zum Anordnen und elektrischen Kontaktieren des wenigstens einen LED-Chips konfiguriert. Die zumindest eine Montagefläche umfasst wenigstens einen ersten elektrischen Anschluss sowie wenigstens einen zweiten elektrischen Anschluss. Der LED-Chip ist dabei vorzugsweise direkt z.B. durch Die-Bonden auf dem ersten elektrischen Anschluss angeordnet und z.B. durch Wire-Bonden mit dem zweiten elektrischen Anschluss verbunden.

Der mindestens eine LED-Chip kann am Grund einer Ausnehmung im Keramiksubstrat angeordnet und elektrisch kontaktiert sein. Die Ausnehmung kann reflektorartig ausgestaltet sein. Dabei bilden die Wandungen der Ausnehmung einen Primärreflektor. Hierbei können die Wandungen reflektierend beschichtet sein.

Vorzugsweise am Grund der Ausnehmung kann sich dabei die Montagefläche befinden.

Die Montagefläche kann alternativ an der Oberfläche des Keramiksubstrats vorgesehen sein.

Besonders bevorzugt ist mindestens eine Grünlage mit mindestens einer ersten elektrischen Anschlussfläche und mit mindestens einer zweiten elektrischen Anschlussfläche zur späteren Oberflächenmontage konfiguriert. Die elektrischen Anschlussflächen sind den elektrischen Anschlüssen der Montagefläche zugeordnet und mit diesen elektrisch verbunden. Hierdurch wird eine oberflächenmontierbare SMD-Leuchtdiode auf Keramiksubstratbasis erhalten, welche prozesstechnisch besonders effektiv auf einen Leuchtmittelträger oder dergleichen bestückt werden und beispielsweise im Reflow-Lötverfahren elektrisch kontaktiert werden kann.

Die so hergestellte SMD-Leuchtdiode auf Keramiksubstratbasis weist dabei durch ihre gute wärmetechnische Anbindung sehr gute thermische Eigenschaften und eine thermische Effizienz ähnlich einer COB-Leuchtdiode auf. Die Leuchtdiode auf Keramiksubstratbasis kann so z.B. im Reflow-Verfahren selbst auf einen Leuchtmittelträger, wie beispielsweise eine Platine oder dergleichen aufgebracht werden.

Die laminierten Grünlagen können mit Elektronikbauteilen konfiguriert sein, so dass in das Keramiksubstrat eine elektronische Steuerschaltung für den wenigstens einen LED-Chip integriert sein kann. Durch die Elektronikbauteile kann die Leuchtkraft von Leuchtdioden auf Keramiksubstratbasis nachträglich getrimmt und damit vereinheitlicht werden.

Das Keramiksubstrat umfasst hierbei vorzugsweise Mehrlagen-Keramik-Schaltungen auf Basis von gesinterten Keramikträgern. Vorzugsweise handelt es sich um Niedertemperatur-Einbrand-Keramiken (LTCC; Low Temperature Cofired Ceramics), aber auch Hochtemperatur-Mehrlagenkeramiken (HTCC; High Temperature Cofired Ceramics) sind denkbar. Dabei können elektronische Steuerschaltungen in das Keramiksubstrat direkt eingebracht bzw. integriert sein, die eine oder mehrere verschiedene elektrische bzw. elektronische Funktionen erfüllen, wie sie von elektronischen Steuerschaltungen für Leuchtdioden bekannt sind. Die elektronischen Steuerschaltungen können in das Keramiksubstrat eingebracht bzw. integriert sein, indem in die Grünlagen entsprechende Elektronikbauteile konfiguriert sind.

Beispiele für in die Grünlagen konfigurierbare Elektronikbauteile sind Leiterbahnen, Kondensatoren, Schutzdioden, Spulen, Widerstände.

Das Konfigurieren bzw. die Konfiguration der Grünlagen zum Keramiksubstrat kann beispielsweise einen oder mehrere der nachfolgenden Schritte umfassen:
Während des so genannten Via-Formings können Durchgangslöcher in die einzelnen Grünlagen gestanzt oder mittels Laserstrahl gelocht werden. Danach können die Löcher während des so genannten Via-Fillings mit einer Leitpaste gefüllt werden. Nach dem Trocknen werden die Leiterbahnen gedruckt. Die einzelnen Lagen werden ausgerichtet und während des so genannten Stackings in einer Pressform gestapelt. Anschließend erfolgt das Laminieren unter Wärme und Druck. Nach dem Laminieren erfolgt das Schneiden auf Endmaß. Danach erfolgt im so genannten Co-Firing das Ausbrennen. Das Co-Firing kann zweistufig erfolgen. Zunächst z.B. im Konvektionsofen beispielsweise für eine Stunde bei z.B. 350°C. Hierbei werden 85 % der organischen Bestandteile ausgebrannt. Anschließend kann in einer zweiten Stufe das Brennen im normalen Dickschichtofen beispielsweise bei 850°C erfolgen.

Einbrand oder Mehrlagenkeramiken können mit Einrichtungen beispielsweise für die Dickschicht-Hybridtechnik gedruckt und gebrannte werden. Die für die Grünlagen verwendete Keramikmasse kann mit Plastifikatoren und Lösungsmitteln versehen sein, um das Laminieren unter Druck und Hitze zu ermöglichen. Die Dicke der Grünlagen beträgt beispielsweise ca. 0,1 mm bis 0,3 mm. Für Innenlagen-Leiterbahnen und Durchkontaktierungen sind Silber-, Silber/Palladium- und Goldpasten bekannt, die auf der Grünlage verarbeitet werden können und während des Laminierens und Co-Firings in nahezu gleichem Maße schrumpfen wie die Grünlage. Die Außenlagen können im so genannten post-firing separat eingebrannt werden, um extreme Passgenauigkeit für automatisches Bestücken zu gewährleisten.

Funktionen der in das Keramiksubstrat integrierten elektronischen Steuerschaltung können z.B.:
- eine Regelung und/oder Steuerung der Helligkeit bzw. Leuchtkraft von Leuchtdioden, beispielsweise durch eine pulsweitenmodulierte Taktung der Stromversorgung für einen außerhalb des für das menschliche Auge wahrnehmbaren Bereichs gepulsten Betrieb,
- eine Kompensation oder Vermeidung elektromagnetischer Störungen, beispielsweise aufgebaut aus Kondensatoren und/oder Ferriten,
- einen Schutz der Leuchtdiode z.B. vor einer Überspannung des Bordnetzes oder vor fehlerhafter Polung, beispielsweise umfassen eine oder mehrere Zenerdioden,
- eine Anpassung und Homogenisierung der Leuchtkraft einzelner Leuchtdioden z.B. innerhalb eines gruppenweise betriebenen Leuchtdiodenarrays umfassen.

Beispielsweise kann die elektronische Steuerschaltung ein Elektronikbauteil in Form zumindest eines in einer an die Oberfläche des Keramiksubstrats reichenden Grünlage integrierten elektrischen Widerstands umfassen. Der elektrische Widerstand selbst befindet sich hierbei an der Oberfläche des Keramiksubstrats bzw. bildet einen Teil der Oberfläche des Keramiksubstrats. Besonders bevorzugt ist der elektrische Widerstand nachträglich konfigurierbar.

Beispielsweise kann der elektrische Widerstand nachträglich laserkonfigurierbar sein. Dabei kann der Widerstand oder können Widerstände gegebenenfalls mittels Lasertrimmen nachträglich z.B. an den aufgebrachten LED-Chip angepasst werden. Hierzu wird vermittels eines Laserstrahls nachträglich der in seiner Dicke beispielsweise die ganze Stärke einer Grünlage einnehmende elektrische Widerstand in seiner Breite abgetragen. Hierdurch verringert sich der einer elektrischen Leitung zur Verfügung stehende Querschnitt des elektrischen Widerstands, so dass sich dessen ohmscher Widerstand erhöht.

Die Leuchtdiode auf Keramiksubstratbasis kann mit einer Primäroptik versehen sein.

Die Leuchtdiode auf Keramiksubstratbasis kann beispielsweise nachträglich mit einer angespritzten Primäroptik versehen werden und erreicht dadurch optische Eigenschaften wie THT-Leuchtdioden.

Die Primäroptik kann beispielsweise ein flächiger Aufbau oder eine einfache Linsengeometrie sein, die den LED-Chip ausschließlich schützt. Alternativ oder zusätzlich ist denkbar, dass die Primäroptik eine spezielle Optik umfasst, die eine Strahlformung des vom LED-Chip ausgestrahlten Lichts erlaubt. Die Primäroptik kann durch ein Spritzgießverfahren hergestellt sein. Die Primäroptik kann eine aufgesteckte oder angeklebte Linse bzw. Optik umfassen und/oder eine angespritzte Linse bzw. Optik. Hierdurch wird die hohe thermische Effizienz der Leuchtdiode auf Keramiksubstratbasis mit der hohen optischen Effizienz, wie sie z.B. von THT-Leuchtdioden mit angespritzter Primäroptik bekannt ist, kombiniert.

Vorteile der Erfindung gegenüber dem Stand der Technik ergeben sich unter Anderem durch:
- Eine erhöhte Lebensdauer der Leuchtdiode auf Keramiksubstratbasis.
- Die Temperaturleitfähigkeit der Keramik ist je nach Material wählbar und kann entsprechend den Anforderungen angepasst werden. Da beispielsweise im Kraftfahrzeugbereich eingesetzte Leuchtdioden Umgebungstemperaturen in einem Bereich von -40°C bis +90°C ausgesetzt sind, trägt eine solche Anpassung einer erhöhten Lebensdauer der Leuchtdiode bei.
- Die gute Wärmeableitung trägt direkt zur hohen Effizienz der Leuchtdiode bei, da die Lichtleistung mit steigender Wärme degradiert. Wird die vom LED-Chip erzeugte Wärme effizient über das Keramiksubstrat an die Umgebung, z.B. auf das umgebende Material eines Leuchtmittelträgers abgeführt, so bleibt die emittierte Lichtleistung des LED-Chips hoch bzw. der LED-Chip kann mit höherem Strom betrieben werden, was zu einer Erhöhung des Lichtstromes führt.
- Durch die Möglichkeit, eine z.B. im Spritzgießprozess hergestellte Primäroptik vorzusehen, wird eine höhere optische Effizienz der Leuchtdiode auf Keramiksubstratbasis im Vergleich zu herkömmlichen SMD-Leuchtdioden erzielt.
- Gegenüber THT-Leuchtdioden wird eine höhere thermische Effizienz erreicht.
- Durch eine entsprechende Konfiguration der Grünlagen mit Anschlussflächen kann die Leuchtdiode auf Keramiksubstratbasis z.B. im kostengünstigen Reflow-Verfahren oberflächenmontiert werden.
- Zusätzlich zu diesen technischen Vorteilen wird die Lagerhaltung notwendiger elektronischer Bauteile verringert. Dies bedeutet vor allen Dingen eine Effizienzsteigerung im Bereich Einkauf, Transport, Lager und letztlich auch in der Bestückung.
- Eine Verpolschutz-Diode kann direkt in das Keramiksubstrat der Leuchtdiode auf Keramiksubstratbasis eingebracht werden. Hierdurch wird eine unbeabsichtigten Zerstörung durch z.B. Verpolung vorgebeugt.
- Durch die in das Keramiksubstrat integrierbaren Elektronikbauteile bis hin zu vollständigen elektronischen Steuerschaltungen wird der Bestückungsaufwand für die Beschaltung der Leuchtdiode auf Keramiksubstratbasis im Vergleich zu einer Bestückung von Leuchtdioden und separaten Elektronikbauteilen bzw. elektronischen Steuerschaltungen nach dem Stand der Technik verringert.
- EMV-Komponenten (EMV; Elektromagnetische Verträglichkeit) können direkt an die Leuchtdiode auf Keramiksubstratbasis angeschlossen oder in das Keramiksubstrat integriert werden, was zur höheren EMV-Stabilität führt.

Die Erfindung wird nachfolgend anhand von in den Zeichnungen dargestellten Ausführungsbeispielen näher erläutert. Darin bezeichnen gleiche Bezugszeichen gleiche oder gleich wirkende Elemente. Es ist für einen Fachmann vorstellbar, dass Abwandlungen oder Änderungen der Erfindung von den bevorzugten Ausführungsbeispielen gemacht werden können, ohne dabei den Schutzbereich der in der Beschreibung genannten oder in den Ansprüchen geschützten Gegenstände zu verlassen.

Es zeigen in schematischer Darstellung:

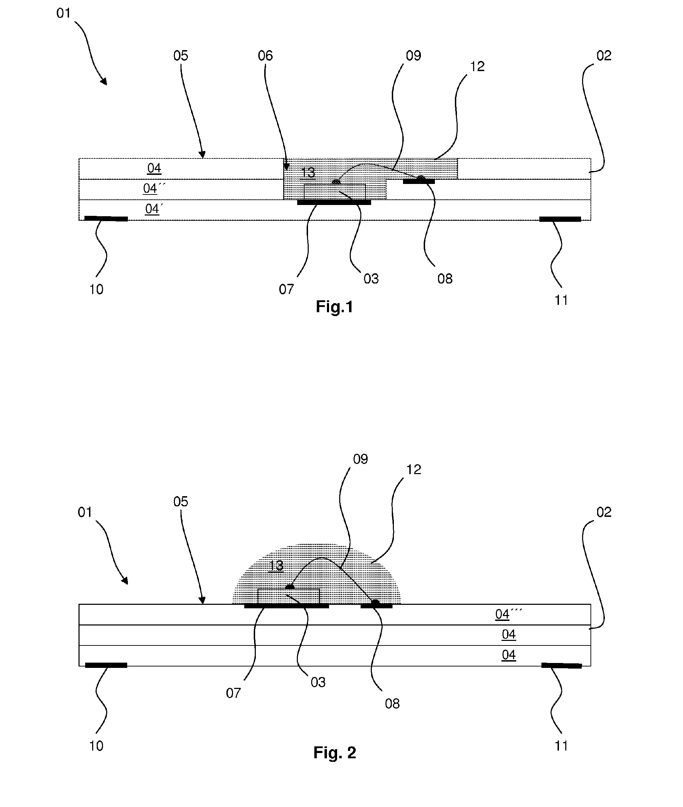

- Fig. 1: ein erstes Ausführungsbeispiel einer Leuchtdiode auf Keramiksubstratbasis mit einem in einer Ausnehmung im Keramiksubstrat aus mehreren Grünlagen angeordneten und in einer Primäroptik eingebetteten LED-Chip.
- Fig. 2: ein zweites Ausführungsbeispiel einer Leuchtdiode auf Keramiksubstratbasis mit einem auf der Oberfläche des Keramiksubstrats aus mehreren Grünlagen angeordneten und in einer Primäroptik eingebetteten LED-Chip.

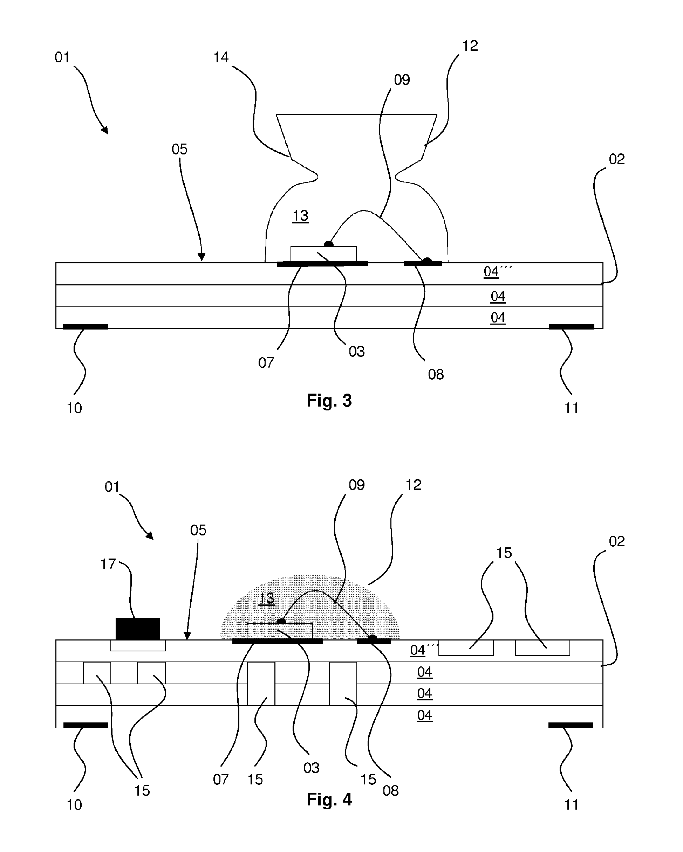

- Fig. 3: ein drittes Ausführungsbeispiel einer Leuchtdiode auf Keramiksubstratbasis mit einem auf der Oberfläche des Keramiksubstrats aus mehreren Grünlagen angeordneten LED-Chip und einer Primäroptik.
- Fig. 4: ein viertes Ausführungsbeispiel einer Leuchtdiode auf Keramiksubstratbasis mit einem auf der Oberfläche des Keramiksubstrats angeordneten und in einer Primäroptik eingebetteten LED-Chip sowie mit einer in das Keramiksubstrat aus mehreren Grünlagen integrierten elektronischen Steuerschaltung bestehend aus wenigstens einem auf der Oberfläche des Keramiksubstrats angeordneten Elektronikbauteil und mindestens einer mit mindestens einem Elektronikbauteil konfigurierten Grünlage des Keramiksubstrats.

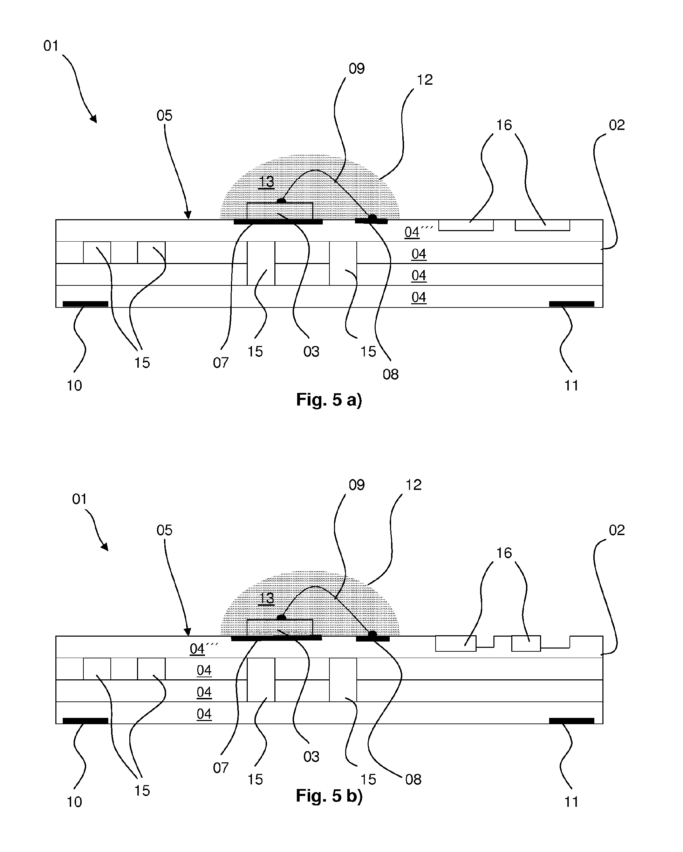

- Fig. 5: ein fünftes Ausführungsbeispiel einer Leuchtdiode auf Keramiksubstratbasis mit einem auf der Oberfläche des Keramiksubstrats angeordneten und in einer Primäroptik eingebetteten LED-Chip sowie mit mindestens einer mit mindestens einem Elektronikbauteil in Form eines nachträglich konfigurierbaren elektrischen Widerstands konfigurierten, an die Oberfläche des Keramiksubstrats reichenden Grünlage des Keramiksubstrats, wobei der elektrische Widerstand sich an der Oberfläche des Keramiksubstrats befindet und/oder einen Teil der Oberfläche des Keramiksubstrats (02) bildet. Dabei zeigt Fig. 5 a) den elektrischen Widerstand vor und Fig. 5 b) nach dessen nachträglicher Konfiguration.

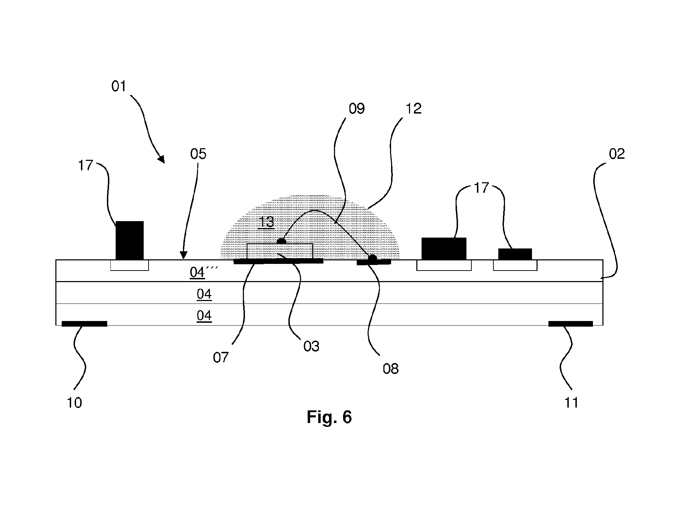

- Fig. 6: ein sechstes Ausführungsbeispiel einer Leuchtdiode auf Keramiksubstratbasis mit einem auf der Oberfläche des Keramiksubstrats angeordneten und in einer Primäroptik eingebetteten LED-Chip sowie mit mindestens einer mit mindestens einem Elektronikbauteil konfigurierten, an die Oberfläche des Keramiksubstrats reichenden Grünlage des Keramiksubstrats mit auf der Oberfläche des Keramiksubstrats angeordneten Elektronikbauteilen.

Eine in den Fig. 1 bis 6 dargestellte Leuchtdiode 01 auf Keramiksubstratbasis umfasst ein Keramiksubstrat 02 und mindestens einen auf dem Keramiksubstrat 02 angeordneten und elektrisch kontaktierten LED-Chip 03. Das Keramiksubstrat ist aus mehreren laminierten Grünlagen 04 hergestellt. Der LED-Chip 03 kann dabei wie in den Fig. 2 bis 6 dargestellt auf der Oberfläche 05 des Keramiksubstrats 02 angeordnet sein, oder wie in Fig. 1 dargestellt in einer im Keramiksubstrat 02 vorgesehenen Ausnehmung 06 angeordnet sein.

Bei der in Fig. 1 dargestellten Leuchtdiode 01 auf Keramiksubstratbasis ist der LED-Chip 03 zunächst durch Die-Bonden auf einem beispielsweise durch eine erste Grünlage 04' gebildeten ersten elektrischen Anschluss 07 angeordnet und elektrisch kontaktiert. Der LED-Chip 03 ist anschließend vermittels Wire-Bonden mit einem zweiten elektrischen Anschluss 08 elektrisch verbunden. Der zweite elektrische Anschluss 08 ist Bestandteil einer zweiten Grünlage 04". Ein Bonddraht 09 verbindet dabei den LED-Chip 03 und den zweiten elektrischen Anschluss 08 der zweiten Grünlage 04".

Die Ausnehmung 06 im Keramiksubstrat 02 kann reflektorartig ausgestaltet sein. Beispielsweise können hierzu die Wandungen der Ausnehmung reflektierend ausgestaltet sein, etwa durch eine reflektierende Beschichtung. Die Ausnehmung 06 bildet so einen Primärreflektor für den LED-Chip 03.

Bei den in den Fig. 2 bis 6 dargestellten Leuchtdioden 01 auf Keramiksubstratbasis ist der LED-Chip 03 zunächst durch Die-Bonden auf einem ersten elektrischen Anschluss 07 angeordnet und elektrisch kontaktiert. Der LED-Chip 03 ist anschließend vermittels Wire-Bonden mit einem zweiten elektrischen Anschluss 08 elektrisch verbunden. Ein Bonddraht 09 verbindet dabei den LED-Chip 03 und den zweiten elektrischen Anschluss 08. Eine an die Oberfläche des Keramiksubstrats 02 reichende Grünlage 04'" ist hierbei mit dem ersten elektrischen Anschluss 07 und mit dem zweiten elektrischen Anschluss 08 konfiguriert.

Der erste elektrische Anschluss 07 und der zweite elektrische Anschluss 08 können eine Montagefläche für den LED-Chip 03 bilden bzw. eine solche umfassen oder von einer solchen umfasst werden. Beispielsweise kann die Montagefläche zum Anordnen und elektrischen Kontaktieren des wenigstens einen LED-Chips 03 in eine laminierte Grünlage 04 konfiguriert sein.

Grundsätzlich ist auch denkbar, dass der LED-Chip 03 in eine Grünlage 04 des Keramiksubstrats integriert ist. Dabei ist wenigstens eine geeignete Grünlage 04 wenigstens mit bevorzugt beiden elektrischen Anschlüssen 07, 08 konfiguriert. Eine beispielsweise benachbarte Grünlage 04 kann mit dem LED-Chip 03 konfiguriert sein. Es ist auch denkbar, dass die elektrischen Anschlüsse 07, 08 und der LED-Chip 03 gemeinsam in eine Grünlage 04 konfiguriert sind.

Mindestens eine Grünlage 04 kann mit mindestens einer ersten elektrischen Anschlussfläche 10 und mit mindestens einer zweiten elektrischen Anschlussfläche 11 zur Oberflächenmontage konfiguriert sein. Die elektrischen Anschlussflächen 10, 11 sind den beispielsweise eine Montagefläche bildenden elektrischen Anschlüssen 07, 08 zugeordnet und mit diesen elektrisch verbunden. Kann die Leuchtdiode auf Keramiksubstratbasis in Oberflächenmontagetechnik (SMT; Surface Mounted Technology) beispielsweise auf einem Leuchtmittelträger einfach, zuverlässig und kostengünstig beispielsweise im Reflow-Verfahren bestückt werden.

Wie in den Fig. 1 bis 6 dargestellt, kann die Leuchtdiode 01 auf Keramiksubstratbasis mit einer dem mindestens einen LED-Chip 03 zugeordneten und diesem bevorzugt unmittelbar vorgesetzen Primäroptik 12 versehen sein.

Die Primäroptik 12 kann durch Anspritzen eines transparenten Materials 13 hergestellt sein. Der LED-Chip 03 kann in das transparente Material 13 der Primäroptik 12 eingebettet sein.

Zur Herstellung der Primäroptik 12 kann das mit dem gebondeten LED-Chip 03 versehene Keramiksubstrat 02 mittels Spritzgieß-Technologie verspritzt werden. Der Spritzguss kann so ausgelegt sein, dass der LED-Aufbau bestehend aus gebondetem LED-Chip 03 und Bonddraht 09 hierdurch lediglich geschützt wird. Es ist aber ebenso möglich eine strahlformende Optik zu integrieren. Hierdurch wird die thermische Effizienz mit der optischen Effizienz kombiniert.

Ist der LED-Chip 03 wie in Fig. 1 in einer Ausnehmung 06 angeordnet, so kann das transparente Material 13 wenigstens den in der Ausnehmung 06 verbleibenden Raum einnehmen. Selbstverständlich kann das transparente Material 13 und damit die Primäroptik 12 auch über die Oberfläche 05 des Keramiksubstrats 02 aus der Ausnehmung 06 herausreichen.

Die Primäroptik 12 kann beispielsweise ein flächiger Aufbau oder eine einfache Linsengeometrie sein, die den LED-Chip 03 ausschließlich schützt. Alternativ oder zusätzlich ist denkbar, dass die Primäroptik 12 wie in Fig. 3 dargestellt eine spezielle Optik 14 umfasst, die eine Strahlformung des vom LED-Chip 03 ausgestrahlten Lichts erlaubt. Die Primäroptik 12 kann durch ein Spritzgießverfahren hergestellt sein. Die Primäroptik 12 kann eine aufgesteckte oder angeklebte Linse bzw. Optik 14 umfassen und/oder eine angespritzte Linse bzw. Optik 14. Hierdurch wird die optische Effizienz der Leuchtdiode auf Keramiksubstratbasis gesteigert.

Die Geometrie der Primäroptik 12 kann dabei während der Herstellung in einem separaten Spritzgießprozess oder während des Anspritzens des wenigstens den verbleibenden Raum der Ausnehmung einnehmenden transparenten Materials 13 oder im Anschluss hieran, beispielsweise vermittels eines zwei- oder mehrstufigen Spritzgießprozesses und/oder vermittels Ur- und anschließendem Umformen festgelegt werden. Hierbei kann die Primäroptik 12 in jeder beliebigen erforderlichen Geometrie hergestellt werden.

Der oder die Anspritzpunkte der durch Anspritzen hergestellten Primäroptik 12 können derart ausgestaltet und/oder angeordnet sein, dass sie sich nicht an einer optisch aktiven Fläche der beispielsweise eine Linse bzw. Optik 14 bildenden Primäroptik 12 befinden. Hierdurch wird die optische Effizienz nochmals gesteigert.

Ein besonderer Vorteil der Leuchtdiode 01 auf Keramiksubstratbasis ist durch die Möglichkeit gegeben, einzelne oder mehrere Elektronikbauteile 15, 16, 17 bis hin zu vollständigen, aus mehreren Elektronikbauteilen 15, 16, 17 bestehende elektronische Steuerschaltungen in das Keramiksubstrat 02 zu integrieren.

Hierzu kann wie in den Fig. 4 und 5 dargestellt, mindestens eine Grünlage 04 mit zumindest einem Elektronikbauteil 15, 16 konfiguriert sein. Alternativ oder zusätzlich ist denkbar, wie in den Fig. 4 und 6 dargestellt wenigstens eine Grünlage 04 derart zu konfigurieren, dass zumindest ein Elektronikbauteil 17 auf der Oberfläche 05 des Keramiksubstrats 02 angeordnet und beispielsweise über in eine oder mehrere Grünlagen 04 des Keramiksubstrats 02 konfigurierte Leiterbahnen mit dem LED-Chip 03 und/oder einer oder mehreren Anschlussflächen 10, 11 und/oder in die selbe oder in andere Grünlagen 04 konfigurierte Elektronikbauteile 15, 16 elektrisch kontaktiert werden kann.

Eine besondere Ausgestaltungsmöglichkeit ergibt sich hierbei durch die in den Fig. 5 a) und 5 b) dargestellte Konfiguration zumindest eines Elektronikbauteils 16 in Form eines elektrischen Widerstands 16 in eine an die Oberfläche 05 des Keramiksubstrats 02 reichende Grünlage 04"'. Der elektrische Widerstand 16 ist dabei besonders bevorzugt derart in die Grünlage 04"' konfiguriert, dass er sich an der Oberfläche 05 des Keramiksubstrats 02 befindet und/oder einen Teil der Oberfläche 05 des Keramiksubstrats 02 bildet.

Ein besonderer Vorteil dieser Ausgestaltungsmöglichkeit ergibt sich dadurch, dass ein solcher in eine Grünlage 04"' integrierter elektrischer Widerstand 16, der sich an der Oberfläche 05 des Keramiksubstrats 02 befindet und/oder einen Teil der Oberfläche 05 des Keramiksubstrats 02 bildet, nachträglich konfigurierbar ist. Diese nachträgliche Konfigurierbarkeit des elektrischen Widerstands 16 kann beispielsweise zur Anpassung und Homogenisierung der Leuchtkraft einzelner Leuchtdioden 01 bzw. deren LED-Chip 03 oder deren LED-Chips 03 genutzt werden, beispielsweise mehrerer in einem Leuchtdiodenarray gruppenweise betriebener Leuchtdioden 01. Darüber hinaus kann der elektrische Widerstand 16 als ein Vorwiderstand für die Anpassung der Vorwärtsspannung der Leuchtdiode 01 an ein Bordnetz eines Kraftfahrzeugs dienen. Durch die nachträgliche Konfigurierbarkeit des elektrischen Widerstands 16 wird das Eingangs erwähnte und unter anderem durch die damit verbundene große Lagerhaltung hohe Kosten verursachende Binning vereinfacht.

Beispielsweise kann der elektrische Widerstand 16 nachträglich laserkonfigurierbar sein. Bei der Laserkonfiguration wird der elektrische Widerstand 16 mittels Lasertrimmen nachträglich z.B. an einen oder mehrere LED-Chips 03 der Leuchtdiode 01 angepasst. Hierzu wird der elektrische Widerstand 16 nachdem die Leuchtdiode 01 wie in Fig. 5 a) dargestellt fertig gestellt wurde in seinem Querschnitt verändert. Fig. 5 b) zeigt beispielhaft eine Leuchtdiode 01 auf Keramiksubstratbasis mit einem nachträglich in seinen Querschnittsabmessungen durch Lasertrimmen veränderten elektrischen Widerstand 16, wohingegen Fig. 5 a) die Leuchtdiode 01 mit dem elektrischen Widerstand 16 vor dem Lasertrimmen zeigt. Beim Lasertrimmen wird vermittels eines Laserstrahls nachträglich der in seiner Dicke beispielsweise die ganze Stärke einer Grünlage 04"' einnehmende elektrische Widerstand 16 beispielsweise in seiner Breite und/oder Dicke abgetragen. Hierdurch verringert sich der einer elektrischen Leitung zur Verfügung stehende Querschnitt des elektrischen Widerstands 16, so dass sich dessen ohmscher Widerstand erhöht.

Durch die Integration von LED-Chip 03, Schaltungs-Elektronik aus Elektronikbauteilen 15, 16, 17 und Primäroptik 12 zumindest zum überwiegenden Teil in ein aus mehreren laminierten Grünlagen 04 hergestelltes Keramiksubstrat 02 können thermische und optische Effizienz in die Leuchtdiode 01 auf Keramiksubstratbasis integriert werden, wie sie bislang nur von COB-Leuchtdioden (thermisch) und THT-Leuchtdioden (optisch) bekannt sind. Darüber hinaus erlaubt eine entsprechende Konfiguration der Grünlagen 04 mit elektrischen Anschlussflächen 10, 11 zudem eine prozesstechnisch vorzuziehende, kostengünstige SMT-Bestückung der Leuchtdiode 01 auf Keramiksubstratbasis.

Darüber hinaus kann vermittels der Leuchtdiode 01 auf Keramiksubstratbasis die Menge der zu lagernden Bauelemente der verschiedenen elektronischen Bauteile zusätzlich verringert werden.

Sind in die Leuchtdiode 01 auf Keramiksubstratbasis integrierte Elektronikbauteile 15, 16 vorgesehen, so wird der Montageprozess bei der Bestückung von Leuchtmittelträgern und/oder Platinen nochmals vereinfacht, da die bereits in der Leuchtdiode 01 auf Keramiksubstratbasis integrierten Elektronikbauteile 15, 16 nicht gesondert bestückt werden müssen. Ebenso verhält es sich für die auf dem Keramiksubstrat 02 der Leuchtdiode 01 angeordneten Elektronikbauteile 17.

Wichtig ist hervorzuheben, dass die zur Herstellung der Leuchtdiode 01 auf Keramiksubstratbasis zum Einsatz kommende keramische Mehrlagentechnik eine Schlüsseltechnologie zur Herstellung komplexer, hochintegrierter keramischer Bauteile darstellt. Diese Technologie geht von keramischen Grünlagen 04 aus, die über ein mehrstufiges Verfahren zu einer hier als Keramiksubstrat 02 bezeichneten, funktionalen Mehrlagen-Keramik verarbeitet werden. Der Prozess umfasst folgende grundlegende Verarbeitungsschritte:
- Stanzen:: Hier wird für jede einzelne Grünlage 04 die Außenkontur der Leuchtdiode 01 auf Keramiksubstratbasis festgelegt. Zusätzlich werden hier auch Strukturen innerhalb der Grünlage 04 festgelegt.
- Schneiden:: Das Stanzen kann zusätzlich durch einen Schneidprozess unterstützt und erweitert werden, beispielsweise um eine besonders genaue Maßhaltigkeit zu erreichen.
- Metallisieren:: Beim Metallisieren werden die Leiterbahn-Strukturen auf den Grünlagen 04 aufgebracht und passive Bauelemente aufgebaut. Zu den passiven Bauelementen zählen insbesondere Leiterbahnen.
- Stapeln:: Die einzeln vorbereiteten Grünlagen 04 werden nach deren Vorbereitung entsprechend der Strukturen aufeinander geschichtet.
- Laminieren:: Der Grünlagen-Stapel wird vor dem abschließenden Schritt laminiert um eventuelle Verschiebungen im Lagen-Verbund zu verhindern.
- Co-Firing:: Zuletzt werden die so verbundenen Grünlagen 04 mit dem Sintern zum Keramiksubstrat 02 gebrannt.

Das Verfahren bietet ein enormes Potential zur Integration unterschiedlicher Materialien bei gleichzeitiger Herstellung komplexer dreidimensionaler Strukturen über das Prinzip des schichtweisen Aufbaus.

Mittels dieser flexiblen Fertigungstechnologie lassen sich elektronische Schaltungselemente direkt als Metallschicht in Zwischenlagen oder über mehrere Lagen des Keramiksubstrats 02 der Leuchtdiode 01 integrieren. Darüber hinaus weist keramisches Material weitere entscheidende Vorteile für Leuchtdioden auf, z. B. den thermischen Ausdehnungskoeffizient des Werkstoffes. Dabei sind hier verschiedene Material-Konstellationen denkbar.

Widerstände 16 können hierbei so integriert werden, dass diese an der Oberfläche 05 des Keramiksubstrats 02 liegen und mittels eines nachträglichen Anpassungsverfahrens auf den notwendigen ohmschen Widerstand getrimmt werden können. Dies kann beispielsweise über ein Lasertrimm-Verfahren erfolgen.

Die als Mehrlagen-Keramik-Schaltung ausgeführte Leuchtdiode 01 auf Keramiksubstratbasis kann so ausgelegt werden, dass ein oder mehrere LED-Chips 03 auf oder in diese integriert werden können.

Weitere schaltungstechnisch notwendige Elektronikbauteile 15, 16, 17 werden auf die innen und/oder außen liegenden Grünlagen 04 des Keramiksubstrats 02 in die Leuchtdiode 01 integriert und/oder aufgebracht. Somit ersetzt die Leuchtdiode 01 auf Keramiksubstratbasis eine ganze Reihe von diskreten Elektronikbauteilen, die nach dem Stand der Technik separat auf einen Leuchtmittelträger oder auf eine Platine bestückt werden müssen.

Hierdurch trägt die Leuchtdiode 01 auf Keramiksubstratbasis erheblich zu einer Einsparung von Bestückungszeit und -kosten bei, ebenso zu einer Verringerung der Kosten und des Aufwands zur Lagerhaltung verschiedener diskreter SMD- oder THT-Elektronikbauteile. Darüber hinaus verringert die Leuchtdiode 01 auf Keramiksubstratbasis den Schaltungsaufwand insgesamt.

Ferner können Komponenten für die Elektromagnetische Verträglichkeit (EMV) direkt in die Leuchtdiode 01 auf Keramiksubstratbasis integriert werden. Hierzu können für die EMV vorteilhaft vorgesehene Elektronikbauteile 15, 16, 17 direkt in eine oder mehrere Grünlagen 04 des Keramiksubstrats 02 konfiguriert werden. Da es für die EMV-Stabilität vorteilhaft ist, beispielsweise Kondensatoren räumlich möglichst nahe am LED-Chip 03 anzuordnen, ergibt sich durch die erfindungsgemäße Leuchtdiode 01 auf Keramiksubstratbasis ein weiterer Vorteil gegenüber dem Stand der Technik.

Die Erfindung ist insbesondere im Bereich der Herstellung von beispielsweise als Lichtquellen für Leuchten, wie etwa für Kraftfahrzeugleuchten, vorgesehenen, beispielsweise oberflächenmotierbaren Leuchtdioden gewerblich anwendbar.

### Bezugszeichenliste

- 01: Leuchtdiode auf Keramiksubstratbasis
- 02: Keramiksubstrat
- 03: LED-Chip
- 04, 04', 04", 04": Grünlage
- 05: Oberfläche des Keramiksubstrats
- 06: Ausnehmung
- 07: erster elektrischer Anschluss
- 08: zweiter elektrischer Anschluss
- 09: Bonddraht
- 10: erste elektrische Anschlussfläche
- 11: zweite elektrische Anschlussfläche
- 12: Primäroptik
- 13: transparentes Material
- 14: Linse bzw. Optik
- 15: Elektronikbauteil
- 16: Elektronikbauteil
- 17: Elektronikbauteil

## Patentansprüche

1. Leuchtdiode (01) auf Keramiksubstratbasis umfassend ein Keramiksubstrat (02) und mindestens einen auf dem Keramiksubstrat (02) angeordneten und elektrisch kontaktierten LED-Chip (03),
**gekennzeichnet durch**
ein aus mehreren laminierten Grünlagen (04) hergestelltes Keramiksubstrat (02).

2. Leuchtdiode nach Anspruch 1,
**dadurch gekennzeichnet,**
**dass** der LED-Chip (03) durch Die- und Wire-Bonden auf dem Keramiksubstrat (02) angeordnet und elektrisch kontaktiert ist.

3. Leuchtdiode nach Anspruch 1,
**dadurch gekennzeichnet,**
**dass** der LED-Chip (03) in eine Grünlage (04) des Keramiksubstrats (02) integriert ist.

4. Leuchtdiode nach Anspruch 1, 2 oder 3,
**dadurch gekennzeichnet,**
**dass** wenigstens eine laminierte Grünlage (04) mit zumindest einer Montagefläche (07, 08) zum Anordnen und elektrischen Kontaktieren des wenigstens einen LED-Chips (03) konfiguriert ist.

5. Leuchtdiode nach Anspruch 4,
**dadurch gekennzeichnet,**
**dass** die zumindest eine Montagefläche wenigstens einen ersten elektrischen Anschluss (07) sowie wenigstens einen zweiten elektrischen Anschluss (08) umfasst.

6. Leuchtdiode nach einem der vorhergehenden Ansprüche,
**gekennzeichnet durch**
wenigstens eine Ausnehmung (06) im Keramiksubstrat (02), in welcher der mindestens eine LED-Chip (03) angeordnet und elektrisch kontaktiert ist.

7. Leuchtdiode nach Anspruch 6,
**dadurch gekennzeichnet,**
**dass** die Ausnehmung (06) reflektorartig ausgestaltet ist.

8. Leuchtdiode nach einem der vorhergehenden Ansprüche,
**dadurch gekennzeichnet,**
**dass** mindestens eine Grünlage (04) mit mindestens einer ersten elektrischen Anschlussfläche (10) und mit mindestens einer zweiten elektrischen Anschlussfläche (11) zur Oberflächenmontage konfiguriert ist.

9. Leuchtdiode nach einem der vorhergehenden Ansprüche,
**dadurch gekennzeichnet,**
**dass** mindestens eine Grünlage (04) mit mindestens einem Elektronikbauteil (15, 16) konfiguriert ist.

10. Leuchtdiode nach Anspruch 9,
**dadurch gekennzeichnet,**
**dass** das mindestens eine Elektronikbauteil (15, 16) wenigstens eine Leiterbahn und/oder zumindest einen Kondensator und/oder mindestens eine Schutzdiode und/oder wenigstens eine Spule und/oder zumindest einen elektrischen Widerstand umfasst.

11. Leuchtdiode nach einem der vorhergehenden Ansprüche,
**gekennzeichnet durch**
zumindest einen in einer an die Oberfläche (05) des Keramiksubstrats (02) reichenden Grünlage (04) integrierten elektrischen Widerstand (16), welcher sich an der Oberfläche (05) des Keramiksubstrats (02) befindet und/oder einen Teil der Oberfläche (05) des Keramiksubstrats (02) bildet.

12. Leuchtdiode nach Anspruch 11,
**dadurch gekennzeichnet,**
**dass** der elektrische Widerstand (16) nachträglich konfigurierbar ist.

13. Leuchtdiode nach Anspruch 12,
**dadurch gekennzeichnet,**
**dass** der elektrische Widerstand (16) nachträglich laserkonfigurierbar ist.

14. Leuchtdiode nach einem der vorhergehenden Ansprüche,
**gekennzeichnet durch**
mindestens eine in das Keramiksubstrat (02) integrierte elektronische Steuerschaltung für den wenigstens einen LED-Chip (03), welche elektronische Steuerschaltung mindestens ein in wenigstens eine Grünlage (04) konfiguriertes Elektronikbauteil (15, 16) umfasst.

15. Leuchtdiode nach einem der vorhergehenden Ansprüche,
**dadurch gekennzeichnet,**
**dass** die Leuchtdiode (01) mit einer Primäroptik (12) versehen ist.

## Geänderte Patentansprüche

### Geänderte Patentansprüche gemäss Regel 137(2) EPÜ.

**1.** Leuchtdiode (01) auf Keramiksubstratbasis umfassend ein aus mehreren laminierten Grünlagen (04) hergestelltes Keramiksubstrat (02) und mindestens einen auf dem Keramiksubstrat (02) angeordneten und elektrisch kontaktierten LED-Chip (03),
**dadurch gekennzeichnet,**
**dass** mindestens eine Grünlage (04) mit mindestens einem Elektronikbauteil (15, 16) konfiguriert ist, wobei das mindestens eine Elektronikbauteil (15, 16) wenigstens einen Kondensator und/oder mindestens eine Schutzdiode und/oder wenigstens eine Spule und/oder zumindest einen elektrischen Widerstand umfasst und die Leuchtdiode (01) mit einer Primäroptik (12) versehen ist.

**2.** Leuchtdiode nach Anspruch 1,
**gekennzeichnet durch**
dass der LED-Chip (03) **durch** Die- und Wire-Bonden auf dem Keramiksubstrat (02) angeordnet und elektrisch kontaktiert ist.

**3.** Leuchtdiode nach Anspruch 1,
**dadurch gekennzeichnet,**
**dass** der LED-Chip (03) in eine Grünlage (04) des Keramiksubstrats (02) integriert ist.

**4.** Leuchtdiode nach Anspruch 1, 2 oder 3,
**dadurch gekennzeichnet,**
**dass** wenigstens eine laminierte Grünlage (04) mit zumindest einer Montagefläche (07, 08) zum Anordnen und elektrischen Kontaktieren des wenigstens einen LED-Chips (03) konfiguriert ist.

**5.** Leuchtdiode nach Anspruch 4,
**dadurch gekennzeichnet,**
**dass** die zumindest eine Montagefläche wenigstens einen ersten elektrischen Anschluss (07) sowie wenigstens einen zweiten elektrischen Anschluss (08) umfasst.

**6.** Leuchtdiode nach einem der vorhergehenden Ansprüche,
**gekennzeichnet durch**
wenigstens eine Ausnehmung (06) im Keramiksubstrat (02), in welcher der mindestens eine LED-Chip (03) angeordnet und elektrisch kontaktiert ist.

**7.** Leuchtdiode nach Anspruch 6,
**dadurch gekennzeichnet,**
**dass** die Ausnehmung (06) reflektorartig ausgestaltet ist.

**8.** Leuchtdiode nach einem der vorhergehenden Ansprüche,
**dadurch gekennzeichnet,**
**dass** mindestens eine Grünlage (04) mit mindestens einer ersten elektrischen Anschlussfläche (10) und mit mindestens einer zweiten elektrischen Anschlussfläche (11) zur Oberflächenmontage konfiguriert ist.

**9.** Leuchtdiode nach einem der vorhergehenden Ansprüche,
**gekennzeichnet durch**
zumindest einen in einer an die Oberfläche (05) des Keramiksubstrats (02) reichenden Grünlage (04) integrierten elektrischen Widerstand (16), welcher sich an der Oberfläche (05) des Keramiksubstrats (02) befindet und/oder einen Teil der Oberfläche (05) des Keramiksubstrats (02) bildet.

**10.** Leuchtdiode nach Anspruch 9,
**dadurch gekennzeichnet,**
**dass** der elektrische Widerstand (16) nachträglich konfigurierbar ist.

**11.** Leuchtdiode nach Anspruch 10,
**dadurch gekennzeichnet,**
**dass** der elektrische Widerstand (16) nachträglich laserkonfigurierbar ist.

**12.** Leuchtdiode nach einem der vorhergehenden Ansprüche,
**gekennzeichnet durch**
mindestens eine in das Keramiksubstrat (02) integrierte elektronische Steuerschaltung für den wenigstens einen LED-Chip (03), welche elektronische Steuerschaltung mindestens ein in wenigstens eine Grünlage (04) konfiguriertes Elektronikbauteil (15, 16) umfasst.
